# EUROPÄISCHE PATENTSCHRIFT

(11) **EP 0 768 387 B1**
(45) Veröffentlichungstag und Bekanntmachung des Hinweises auf die Patenterteilung: **25.10.2000**
(21) Anmeldenummer: 96113051.5
(22) Anmeldetag: 14.08.1996
(51) Int. Cl.: C23C 14/14, C23C 14/34, B22D 21/00, B22D 21/04

(54) **Verfahren zur Herstellung feinkörniger Sputtertargets**
Process for the production of fine grained sputtering targets
Procédé pour la fabrication des cibles de pulvérisation à grains fins

(30) Priorität: 11.10.1995 DE 19537765
(43) Veröffentlichungstag der Anmeldung: 16.04.1997
(73) Patentinhaber: LEYBOLD MATERIALS GmbH, D-63450 Hanau (DE)
(72) Erfinder: Schlott, Martin, Dr., 63454 Hanau (DE); Heindel, Josef, 63512 Hainburg (DE)

(56) Entgegenhaltungen:
- EP-A- 0 466 617
- US-A- 3 863 703
- US-A- 5 087 297
- INT. CONF. PROCESS. MATER. PROP., 1ST (1993), 905-8. EDITOR(S): HENEIN, HANI;OKI, TAKEO. PUBLISHER: MINER. MET. MATER. SOC, WARRENDALE, PA. CODEN: 59TDAS, 1993, XP000614504 ADAMS, JOHN ET AL: "Containerless processing and characterization of high purity aluminum alloys"
- PATENT ABSTRACTS OF JAPAN vol. 007, no. 034 (C-150), 10.Februar 1983 & JP-A-57 185973 (MITSUI KINZOKU KOGYO KK), 16.November 1982,

## Beschreibung

Die Erfindung betrifft ein Sputtertarget mit einem Breiten- zu Dickenverhältnis von mindestens 5:1 aus an Luft schmelzbaren Metallen oder Metallegierungen aus der Serie Sn, In, Bi, Pb, Zn, Al mit einer Liquidustemperatur unter 700°C sowie das Verfahren zu seiner Herstellung.

Beim Schmelzen und Gießen hochreiner Metalle (typische Reinheit 99,9% oder besser) ergeben sich entsprechend der jeweiligen Erstarrungsverhältnisse häufig sehr grobkristalline Gefüge. Dies ist vor allem der Fall, wenn die Abkühlung entsprechend hoher Gußgewichte und Geometrien langsam abläuft. Je nach Einsatzzweck stellen solche grobkristallinen Gefüge ein Problem dar.

Zum Beispiel werden hochkristalline Sputtertargets aus In, Sn, Bi, Pb, Zn, Al für die Magnetron-Kathodenzerstäubung und Herstellung dünner Schichten eingesetzt. Wegen der kornorientierungsabhängigen Sputterraten (R. G. Musket and H. P. Smith, Jr., J. Appl. Phys. 39, 3578 (1968)) kann solch ein grobes Gefüge dann zu ungleichmäßigen Schichten führen. Da die Schichtgleichmäßigkeit aber in der Regel sehr eng toleriert ist (z.B. < ± 2%), ist es eine wesentliche Aufgabe bei der Herstellung solcher Werkstoffe, ein feinkörniges Material zu erzielen.

EP-A-0 466 617 beschreibt ein Verfahren zur Herstellung hochreiner Sputtertargets aus Al-Si Legierungen mit einer Korngröße unter 100 µm, wobei die erstarrten Targets einer thermomechanishen Behandlung unterzogen werden.

In der Regel wird man hochreine Werkstoffe durch Schmelzen, Gießen und anschließendes Walzen feinkörnig machen. Dieses Verfahren hat jedoch den großen Nachteil, daß eine erhebliche mechanische Nacharbeit erforderlich ist, ehe die gewünschten rechteckigen, planparallelen Platten zum Einsatz als Sputtertargets zur Verfügung stehen. Neben den Kosten für die Bearbeitung entsteht außerdem noch ein beträchtlicher Materialverlust.

Beide Nachteile sollen mit dem erfindungsgemäßen Verfahren vermieden werden. Daher sollte das Formgeben durch endformnahes Gießen in flache Wannen erfolgen. Um Lunkerbildung zu vermeiden, ist dabei eine langsame, gerichtet voranschreitende Erstarrung erforderlich. Dies führt jedoch zunächst zu einem nachteiligen, sehr grobkristallinen Gefüge. Im Rahmen einer breit angelegten Versuchsreihe zur Beeinflussung der Erstarrungsfront von luftoffenen Flachgüssen wurden daher verschiedene Möglichkeiten erprobt.

In der Literatur beschriebene Verfahren zur magnetischen, elektromagnetischen sowie Ultraschall-Beeinflussung der Schmelze
( - S. Asai, K. Miyazawa, T. Fukaya and I. Muchi: effects of electric and magnetic currents on solidification process, Metall. Appl. Of Magnetohydrodyn., Proc. Symp. Int. Union Theor. Appl. Mech. (1984), 224-233;
- J. J. Frawley and W. J. Childs: Grain refinement by ultrasonic vibrations of Bismuth, Tin and Bismuth-Tin alloys. Trans. Metall. Soc. of AIME, 245 (Nov. 1969), 2399-2404;
- K. Buxmann: Auswirkungen von Schock, Vibration und Strömung auf die eRstarrung von Metallen. Z. Metallkde. Bd. 63 (9) (1972), 516-521.)
waren wenig erfolgreich. Zwar ließ sich mit geeigneten Anordnungen aus rotierenden Permanentmagneten oder magnetischen Wechselfeldern eine deutliche Badbewegung erreichen, die Kornneubildungsrate wurde jedoch nur mäßig erhöht. Außerdem haben diese Verfahren den Nachteil, daß sie sehr stark von den elektrischen Eigenschaften der Wanne abhängen, in der die Erstarrung durchgeführt werden soll. In der Regel wurden auf diese Weise recht inhomogene Gefüge erhalten.

Mittels Ultraschall lassen sich nur recht kleine Gefäße so in Schwingung versetzen, daß eine ausreichende Keimvervielfachung erreicht wird. Dieses Verfahren stößt bei großen Dimensionen im Bereich von mehr als einem Meter auf erhebliche Schwierigkeiten. Auch mit Tonfrequenzen wurde experimentiert. Hier besteht das Problem vor allem darin, daß sich bei einem offenen Flachguß eine extrem ungleichmäßige Oberflächenstruktur herausbildet. Die dann erforderliche Nacharbeit macht die Vorteile des endformnahen Gießens dann wieder zunichte.

Aufgabe der vorliegenden Erfindung ist es, ein Sputtertarget zu schaffen, das aus hochreinen Werkstoffen mit typisch mindestens 99,9% Reinheit besteht und insbesondere ein Verfahren zur Herstellung derartiger Sputtertargets anzugeben. Diese Aufgabe wird durch das Verfahren gemäß Patentanspruch 1 gelöst.

Gemäß der Erfindung liegt die mittlere Korngröße unter 6 mm, wobei das Target in einem direkten Gußverfahren hergestellt wird und ein Teil der Erstarrungswärme aus dem gerade erstarrten Bereich des Targets durch Aufbringen eines Kühlmediums abgeführt wird. Weitere Einzelheiten und Merkmale sind in den abhängigen Patentansprüchen näher beschrieben und gekennzeichnet.

Es hat sich gezeigt, daß die besten Ergebnisse durch das schnelle Abführen der Erstarrungswärme mittels Aufbringen eines Kühlmediums nahe der Erstarrungsfront erreicht werden. Um eine starke Aufrauhung der Gußoberfläche sowie das Bilden von Lunkerungen zu vermeiden, muß dabei stets die schon erstarrte Zone gekühlt werden. Als besonders geeignet haben sich das Aufsprühen von Wassernebel oder Wasserdampf gezeigt. Aber auch das Abführen der Wärme über eine wasserberieselte Bürste war erfolgreich. Es muß jedoch darauf geachtet werden, daß keine größeren Mengen an Kühlmedium auf die flüssige Schmelze gelangen, da es sonst zu heftigen Gaseruptionen kommen kann.

Mit der oben beschriebenen Methode ließe sich der mittlere Korndurchmesser der untersuchten Werkstoffe um 1 bis 2 Größenordnungen verringern und ein sehr gleichmäßiges Gefüge erzielen.

Die folgenden Beispiele sollen die Erfindung näher erläutern:

### Beispiel 1 (Vergleichsbeispiel)

Eine 800 x 100 x 15 mm große Metallwanne wurde auf ca. 300°C aufgeheizt und anschließend ca. 10 mm hoch mit Sn (99,9%) gleicher Temperatur gefüllt. Die Erstarrung wurde entlang der Längsrichtung durchgeführt und dauerte ca. 45 Minuten. Die so hergestellte Gußplatte wurde überfräst und zeigte später mehrere Zentimeter große Kristallite.

### Beispiel 2 (entsprechend Erfindung)

Ausführung wie in Beispiel 1. Während der Erstarrung wurd ein diffuser Dampfstrahl auf den bereits erstarrten Teil der Gußplatte gerichtet und so geführt, daß der Strahl stets nahe der Grenzlinie fest/flüssig auftraf. Die so hergestellte Gußplatte zeigte eine leicht faltige Oberfläche. Die überfräste Platte wies Körner im Bereich mehrerer Millimeter auf.

### Beispiel 3 (entsprechend Erfindung)

Ausführung wie in Beispiel 2, jetzt jedoch mit einer diffusen Wasserdusche. Die so hergestellte Platte zeigte wieder eine leicht unebene Oberfläche. Nach dem Überfräsen war ein sehr gleichmäßiges Gefüge mit Korngrößen im unteren Millimeterbereich sichtbar.

| Weitere Beispiele sind in der nachfolgenden Tabelle aufgeführt: | | | |
|---|---|---|---|
| Zusammensetzung | Schmelztemperatur (°C) | Abkühlung lt. Erfindung | Korngröße |
| In (3N) | 220 | nein | > 2 cm |
| In (3N) | 220 | Wassernebel | < 3 mm |
| Al (4N) | 700 | nein | > 5 cm |
| Al (4N) | 700 | Schutzgas | < 1 mm |
| Zn (3N) | 460 | nein | > 2 cm |
| Zn (3N) | 460 | Wasserdampf | < 3 mm |
| Pb (3N) | 380 | Wassernebel | < 1 mm |
| Bi (3N) | 330 | Wassernebel | < 1 mm |
| Sn (3N) | 300 | mit Wasser berieselte Bürste | < 4 mm |

## Patentansprüche

1. Verfahren zur Herstellung feinkörniger Sputtertargets mit einer mittleren Korngröße unter 6 mm und mit einem Breiten- zu Dickenverhältnis von mindestens 5:1 aus an Luft schmelzbaren Metallen oder Metallegierungen aus der Serie Sn, In, Bi, Pb, Zn, Al mit einer Liquidustemperatur unterhalb 700°C, **dadurch gekennzeichnet**, daß das Target in einem direkten Gußverfahren hergestellt wird und ein Teil der Erstarrungswärme aus dem gerade erstarrten Bereich des Sputtertargets durch flächiges, feinverteiltes Aufbringen eines Kühlmediums entfernt wird.

2. Verfahren nach Anspruch 1, **dadurch gekennzeichnet**, daß Metalle mit mindestens 99,9% Reinheit eingesetzt werden.

3. Verfahren nach einem der Ansprüche 1 oder 2, **dadurch gekennzeichnet**, daß das Kühlmedium Wasser oder Wasserdampf ist.

4. Verfahren nach einem der Ansprüche 1 und 3, **dadurch gekennzeichnet**, daß das flächige, feinverteilte Aufbringen mittels Aufsprühen erfolgt.

5. Verfahren nach einem der Ansprüche 1 bis 4, **dadurch gekennzeichnet**, daß das flächige, feinverteilte Aufbringen des Kühlmediums mittels einer Bürste oder eines Schwamms erfolgt.

## Claims

1. Method of manufacturing fine-grained sputter targets with an average grain size of less than 6 mm and with a width-to-thickness ratio of at least 5:1 composed of metals or metal alloys meltable by air from the series Sn, In, Bi, Pb, Zn, Al with a liquidus temperature of less than 700°C, characterised in that the target is manufactured in a direct casting process and some of the solidification heat is removed from the region just solidified of the sputter target by large-area, finely distributed application of a coolant.

2. Method according to claim 1, characterised in that metals with at least 99.9% purity are used.

3. Method according to one of claims 1 or 2, characterised in that the coolant is water or water vapour.

4. Method according to one of claims 1 and 3, characterised in that the large-area, finely distributed application is effected by means of spraying.

5. Method according to one of claims 1 to 4, characterised in that the large-area, finely distributed application of the coolant is effected by means of a brush or sponge.

## Revendications

1. Procédé de fabrication de cibles de pulvérisation à grains fins ayant une granulométrie moyenne inférieure à 6 mm et un rapport de la largeur à l'épaisseur d'au moins 5 :1 en métaux ou alliages métalliques fusibles à l'air de la série Sn, In, Bi, Pb, Zn, Al ayant une température du liquidus inférieure à 700°C, caractérisé en ce que la cible est fabriquée dans un procédé de coulée directe et une partie de la chaleur de solidification est retirée du domaine déjà solidifié de la cible de pulvérisation par application finement divisée sur la surface d'un agent réfrigérant.

2. Procédé selon la revendication 1 caractérisé en ce que l'on utilise des métaux d'une pureté d'au moins 99,9%.

3. Procédé selon l'une des revendications 1 et 2 caractérisé en ce que l'agent réfrigérant est l'eau ou la vapeur d'eau.

4. Procédé selon l'une des revendications 1 et 3 caractérisé en ce que l'application finement divisée sur la surface a lieu par pulvérisation.

5. Procédé selon l'une des revendications 1 à 4 caractérisé en ce que l'application finement divisée sur la surface de l'agent réfrigérant a lieu au moyen d'une brosse ou d'une éponge.
